# EUROPEAN PATENT APPLICATION

(11) **EP 4 730 569 A1**
(43) Date of publication of application: **22.04.2026**
(21) Application number: 25167842.1
(22) Date of filing: 01.04.2025
(51) Int. Cl.: H01R 12/70, H01R 12/72, H01R 13/645, H01R 13/6587

(54) **CONNECTOR SYSTEM WITH MULTIPLE GROOVE STRUCTURES AND CONNECTOR THEREOF**

(30) Priority: 16.10.2024 TW 113211232 U; 16.10.2024 TW 113211233 U
(71) Applicant: Amphenol East Asia Limited Taiwan Branch (H.K.), New Taipei City (TW)
(72) Inventor: LIAO, SZU-TING, New Taipei City (TW)
(74) Representative: Bandpay & Greuter

(57) **Abstract**

A connector system with multiple groove structures includes a connector fixable to a circuit board and including a metal housing, an insulting body that can be mounted in the metal housing, and metal terminals that can be disposed in the insulting body. A first inner wall of the metal housing is provided with a blocking portion, and the blocking portion is spaced apart from the insulating body by a first groove. The left inner wall is spaced apart from the insulating body by a left groove, and the right inner wall is spaced apart from the insulating body by a right groove. Accordingly, by the design of the grooves, the connection between the connector and a mating connector is more convenient and more stable.

## Description

### FIELD

The present disclosure is related to a connector, and more particularly to a connector structure having grooves formed between a metal housing and an insulating body on three sides, respectively, so as to achieve multi-directional positional restriction with respect to a mating connector.

### BACKGROUND

The term "connector" generally refers to a connecting element that is used to deliver electronic signals and electric power, including the fitting(s), if any, of the connecting element. A connector serves mainly to establish and maintain the connection between electrical circuits, is responsible for not only the delivery of electricity but also data transfer, and is therefore an important component of any modern electronic system, which, be it a mobile phone, computer, or large industrial machine, cannot carry out its basic functions without the required connectors.

Generally, the stability of connection between two mating connectors has certain impact on the reliability of current and signal transmission through the connectors. The existing connectors, however, are so designed that two mating ones are secured to each other typically only by means of their terminal mechanisms. For example, one of two mating connectors is provided with a mating groove, and there are terminals distributed on the inner wall surface of the mating groove; the other connector is provided with a tongue plate, and there are also terminals distributed on the tongue plate. The tongue plate can be inserted into the mating groove such that the terminals of the two connectors are electrically connected. However, this connection manner is relatively unstable. The connectors can easily separate from each other when impacted or shaken by an external force.

Besides, depending on their uses and installation locations, connectors may vary in structure and type in order to adapt to and satisfy user needs, but overall, there is a design trend for connectors, regardless of their types, to be increasingly light and compact. Nonetheless, this design concept can lead to a connector whose housing is too thin and fragile to provide the desired protection. Accordingly, one of the issues addressed in the present disclosure is to resolve such problems.

### SUMMARY

In order to stand out in the competitive market, based on years of practical, professional experience in designing, processing, and manufacturing various power supplies and/or signal connectors, and the research spirit that strives for excellence, as a result of longtime research and experiments, a connector system with multiple groove structures and the connector thereof are provided in the present disclosure.

Certain aspects of the present disclosure are directed to a connector. The connector includes an insulating body, a plurality of metal terminals and a metal housing. The insulating body is formed with at least one mating groove at the front side thereof. The plurality of metal terminals is configured to be disposed in the insulating body. Each metal terminal has a front section configured to be exposed from the mating groove and a rear section configured to extend out of the insulating body and be fixed to a connection medium (e.g., a circuit board or an electronic cable). The metal housing is formed with a front opening at a front side thereof and configured to be mounted with the insulating body therein. The front opening is in communication with the mating groove. The first inner wall of the metal housing is provided with a blocking portion, and a side of the blocking portion that faces the insulating body is spaced apart from the insulating body by a first groove. The left inner wall and the right inner wall of the metal housing face each other and are both adjacent to the first inner wall, the left inner wall is spaced apart from the insulating body by a left groove, and the right inner wall is spaced apart from the insulating body by a right groove. Accordingly, by the design of the grooves, the connection between the connector and the mating connector is more convenient and more stable.

In certain embodiments, the left end of the first groove is in communication with the left groove, and the right end of the first groove is in communication with the right groove.

In certain embodiments, the metal housing is divided into a front section and a rear section, and the front section is in a form of a frame and has a vertical height greater than a vertical height of the rear section.

In certain embodiments, the metal housing is provided with a left guiding structure and a right guiding structure, the left guiding structure corresponds to the left groove, and the right guiding structure corresponds to the right groove.

In certain embodiments, the left inner wall of the metal housing is recessed to form the left guiding structure, and the right inner wall of the metal housing is recessed to form the right guiding structure.

In certain embodiments, a position of the blocking portion that corresponds to the left groove is provided with the left guiding structure, and a position of the blocking portion that corresponds to the right groove is provided with the right guiding structure.

In certain embodiments, the left guiding structure is of a recessed configuration and the right guiding structure is of a protruding configuration, or the left guiding structure is of a protruding configuration and the right guiding structure is of a recessed configuration.

In certain embodiments, a vertical height of the left guiding structure is different from a vertical height of the right guiding structure.

In certain embodiments, a left end of the first groove is in communication with the left groove, and a right end of the first groove is in communication with the right groove.

In certain embodiments, the metal housing is provided therein with at least one protecting post that protrudes forward, and each of the at least one protecting post is located in the left groove or the right groove and corresponds to the outer side of a side wall of the insulating body.

In certain embodiments, the horizontal width of the protecting post is equal to or greater than the horizontal width of the corresponding side wall of the insulating body.

In certain embodiments, the height of the top side of the protecting post is equal to or greater than the height of the top side of the corresponding side wall of the insulating body.

In certain embodiments, the vertical height of the left protecting post is equal to or greater than two thirds of the vertical height of the corresponding side wall of the insulating body.

In certain embodiments, the front side of the protecting post does not extend beyond the front side of the insulating body.

In certain embodiments, the front side of the protecting post extends beyond the front side of the insulating body.

In certain embodiments, the bottom side of at least one of the protecting post and the metal housing is provided with at least one positioning post.

In certain embodiments, the metal housing is made of cast iron.

In certain embodiments, the connector further includes a cover, the rear side of the metal housing is formed with a rear opening for the insulating body to be inserted into the metal housing along a rear-to-front direction, and the cover is configured to be mounted on the rear side of the metal housing and cover the rear opening completely or partially.

Certain aspects of the present disclosure are directed to a connector system including a circuit board and a connector. The connector is fixable to the circuit board, extending across or adjacent to an edge of the circuit board, and includes insulating body, a plurality of metal terminals and a metal housing. The insulating body is formed with at least one mating groove at the front side thereof. The plurality of metal terminals is configured to be disposed in the insulating body. Each metal terminal has a front section configured to be exposed from the mating groove and a rear section configured to extend out of the insulating body and be fixed to a connection medium. The metal housing is formed with a front opening at a front side thereof and configured to be mounted with the insulating body therein. The front opening is in communication with the mating groove. The first inner wall of the metal housing is provided with a blocking portion, and a side of the blocking portion that faces the insulating body is spaced apart from the insulating body by a first groove. The left inner wall and the right inner wall of the metal housing face each other and are both adjacent to the first inner wall, the left inner wall is spaced apart from the insulating body by a left groove, and the right inner wall is spaced apart from the insulating body by a right groove.

In certain embodiments, the metal housing is divided into a front section and a rear section, the front section is in a form of a frame and has a vertical height greater than a vertical height of the rear section, and the front section is located outside an edge of the circuit board.

In certain embodiments, the metal housing is provided with a left guiding structure and a right guiding structure, the left guiding structure corresponds to the left groove, and the right guiding structure corresponds to the right groove.

In certain embodiments, the left end of the first groove is in communication with the left groove, and the right end of the first groove is in communication with the right groove.

In certain embodiments, the vertical height of the left guiding structure is different from the vertical height of the right guiding structure.

In certain embodiments, the metal housing is provided therein with at least one protecting post that protrudes forward, and each of the at least one protecting post is located in the left groove or the right groove and corresponds to the outer side of a side wall of the insulating body.

In certain embodiments, the horizontal width of the protecting post is equal to or greater than the horizontal width of the corresponding side wall of the insulating body.

In certain embodiments, the height of the top side of the protecting post is equal to or greater than the height of the top side of the corresponding side wall of the insulating body.

In certain embodiments, the vertical height of the left protecting post is equal to or greater than two thirds of the vertical height of the corresponding side wall of the insulating body.

In certain embodiments, the metal housing is made of cast iron.

In certain embodiments, the connector system further includes a cover, the rear side of the metal housing is formed with a rear opening for the insulating body to be inserted into the metal housing along a rear-to-front direction, and the cover is configured to be mounted on the rear side of the metal housing and cover the rear opening completely or partially.

These and other aspects of the present disclosure will become apparent from the following description of the embodiment taken in conjunction with the following drawings and their captions, although variations and modifications therein may be affected without departing from the spirit and scope of the novel concepts of the disclosure.

### BRIEF DESCRIPTION OF THE DRAWINGS

The present disclosure will become more fully understood from the following detailed description and accompanying drawings.
FIG. 1 is a perspective view of a connector system according to certain embodiments of the present disclosure.
FIG. 2 is a front view of a connector system according to certain embodiments of the present disclosure.
FIG. 3 is a side view of a connector system according to certain embodiments of the present disclosure.
FIG. 4 is an exploded view of a connector system according to certain embodiments of the present disclosure.
FIG. 5 is an exploded view of an insulating body and metal terminals according to certain embodiments of the present disclosure.
FIG. 6 is a perspective view of a cross-sectioned connector that is viewed from its front according to certain embodiments of the present disclosure.
FIG. 7 is a perspective view of the cross-sectioned connector that is viewed from its rear according to certain embodiments of the present disclosure.
FIG. 8 is a perspective view of a metal housing that is viewed from its front according to certain embodiments of the present disclosure.
FIG. 9 is a perspective view of the metal housing that is viewed from its rear according to certain embodiments of the present disclosure.
FIG. 10A is a front view of a connector system according to certain embodiments of the present disclosure, which shows the width difference between a first groove and a side groove.
FIG. 10B is a front view of a connector system according to certain embodiments of the present disclosure, which shows the height difference between the first groove and the side groove.
FIG. 11 is a front view of a part of a connector according to certain embodiments of the present disclosure.
FIG. 12A is a top view of a part of a connector according to certain embodiments of the present disclosure, in which a part of the front section of a metal housing is omitted so that a left protecting post and a part of an insulating body can be shown.
FIG. 12B is a top view of a part of a connector according to certain embodiments of the present disclosure, in which a part of the front section of a metal housing is omitted so that a left protecting post and a part of an insulating body can be shown.
FIG. 12C is a top view of a part of a connector according to certain embodiments of the present disclosure, in which a part of the front section of a metal housing is omitted so that a left protecting post and a part of an insulating body can be shown.

### DETAILED DESCRIPTION

The present disclosure is more particularly described in the following examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a", "an", and "the" includes plural reference, and the term "and/or" includes any and all combinations of one or more of the associated listed items. Titles or subtitles can be used herein for the convenience of a reader, which shall have no influence on the scope of the present disclosure.

The accompanying drawings are schematic and may not have been drawn to scale. The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present disclosure or of any exemplified term. Likewise, the present disclosure is not limited to various embodiments given herein. Numbering terms such as "first", "second" or "third" can be used to describe various components, materials, objects, or the like, which are for distinguishing one component/material/object from another one only, and are not intended to, nor should be construed to impose any substantive limitations on the components, materials, objects, or the like. Directional terms (e.g., "front", "rear", "left", "right", "upper/top" and/or "lower/bottom") are explanatory only and are not intended to be restrictive of the scope of the present disclosure.

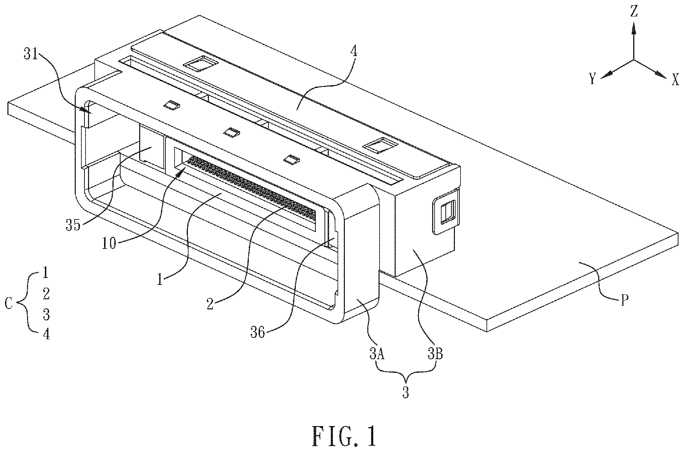

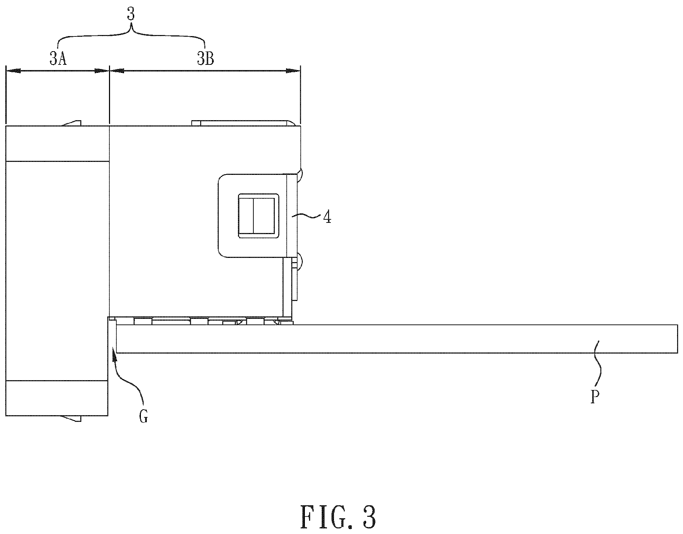

Certain aspects of the present disclosure are directed to a connector system with multiple groove structures and the connector thereof. To facilitate description of component features and relative positional relationship, the spatial configuration of the components as used in the present disclosure is defined by three axes that are perpendicular to one another, namely a transverse axis (the X axis), a longitudinal axis (the Y axis), and a vertical axis (the Z axis). Generally, unless the context clearly dictates otherwise, the transverse axis (the X axis) refers to the direction extending between the right and left sides, wherein the upper left of FIG. 1 is defined as facing the left side of a component, and the lower right of FIG. 1 as facing the right side of a component; the longitudinal axis (the Y axis) refers to the direction extending between the front and rear sides, wherein the lower left of FIG. 1 is defined as facing the front side of a component, and the upper right of FIG. 1 as facing the rear side of a component; and the vertical axis (the Z axis) refers to the direction extending between the top and bottom sides, wherein the top (upper) side of FIG. 1 is defined as facing the top side of a component, and the bottom side of FIG. 1 as facing the bottom (lower) side of a component. In certain embodiments, referring to FIGS. 1-4, the connector system includes a connector C and a circuit board P. The connector C is fixable on the top side of the circuit board P. In view of the positions of the connector C and the circuit board P, there can be two mounting configurations as described as follows.
(1) A portion of the connector C is located in the area of the projection of the top side of the circuit board P while the other portion of the connector C is outside the area of the projection of the top side; in other words, the connector C extends across an edge of the circuit board P, as shown in FIG. 1 and FIG. 3.
(2) The entire connector C is located in the area of the projection of the top side of the circuit board P, and the mating side of the connector C is adjacent to an edge of the circuit board P, wherein the term "adjacent" includes the mating side of the connector C being flush with the edge of the circuit board P.

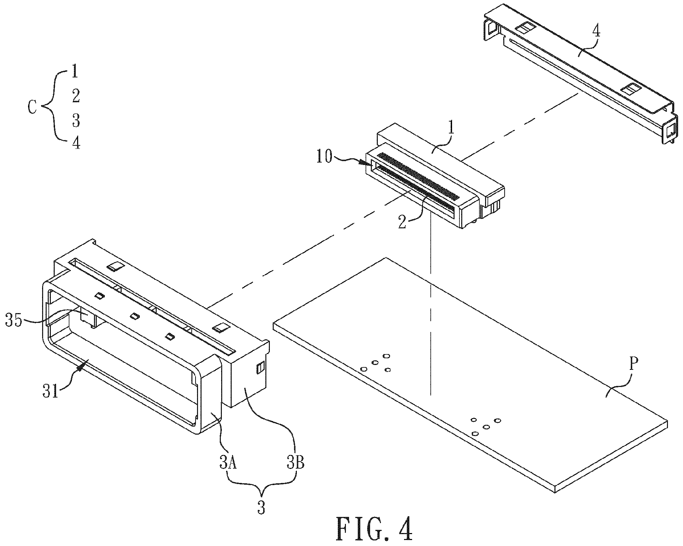

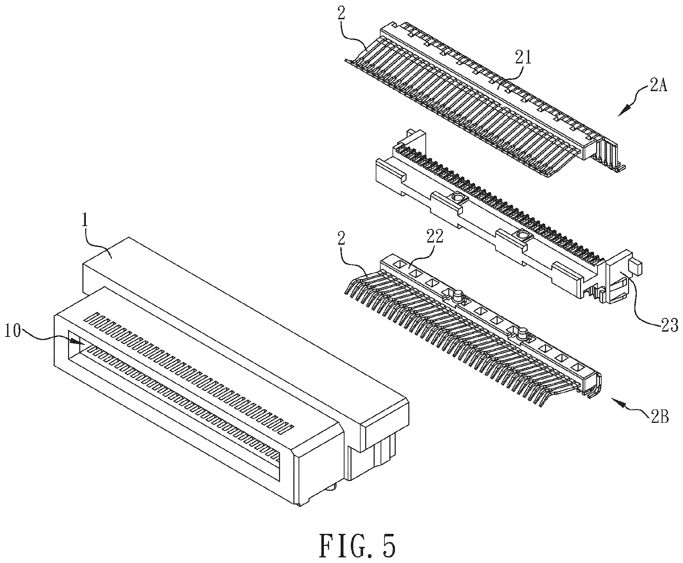

Referring to FIG. 4 and FIG. 5, the connector C includes an insulating body 1, a plurality of metal terminals 2, a metal housing 3, and a cover 4. The front side of the insulating body 1 is formed with a mating groove 10, and the tongue plate of a mating connector can be inserted into the mating groove 10 such that the connector C and the mating connector are connected to each other. However, the present disclosure is not limited thereto. Based on actual product needs, the insulating body 1 can also have a plurality of mating grooves 10, and the mating grooves 10 can be arranged in a horizontal direction or a vertical direction, and can have the same length and/or shape or different lengths and/or shapes.

Referring to FIG. 1 to FIG. 5, the metal terminals 2 can be disposed in the insulating body 1. The metal terminals 2 can be terminals of a single type or of multiple types, and the type(s) of terminals include but are not limited to power terminals, signal terminals, ground terminals, etc. In certain embodiments, some of the metal terminals 2 can be fixed on an upper terminal base 21 to form an upper terminal block 2A while some other metal terminals 2 can be fixed on a lower terminal base 22 to form a lower terminal block 2B. The upper terminal base 21 and the lower terminal base 22 can be mounted on a carrier 23, and then the upper terminal base 21, the lower terminal base 22 and the carrier 23 can be jointly mounted into the insulating body 1. However, the present disclosure is note limited thereto. In certain embodiments, the upper terminal base 21 and the lower terminal base 22 can be directly assembled to each other, dispensing the carrier 2. In certain embodiments, the metal terminals 2 can also be fixed directly into the insulating body 1.

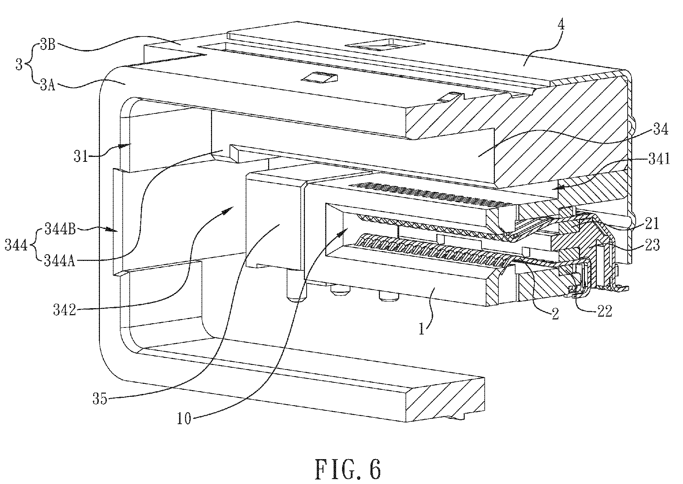

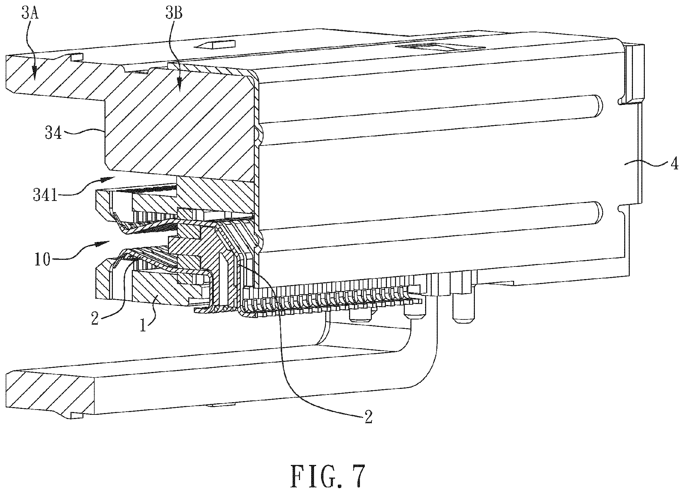

Referring to FIG. 5 to FIG. 7, a front section of each metal terminal 2 can be exposed from the mating groove 10 in order to be electrically connected to the corresponding terminal on the tongue plate of the mating connector. A rear section of each metal terminal 2 can extend out of the insulating body 1 and can be fixed on the circuit board P. In certain embodiments, the rear section of each metal terminal 2 at least has an L shape so as to have a flat contact area suitable for being fixed to the circuit board P through surface mount technique (SMT), and to provide a secure soldering point, ensuring good electrical contact and the desired mechanical strength during assembly. In certain embodiments, based on product needs, for example, if the connector C is a cable-end connector, the circuit board P can be replaced with an electronic cable or another connection medium, and the rear section of each metal terminal can be of another configuration such as a linear shape.

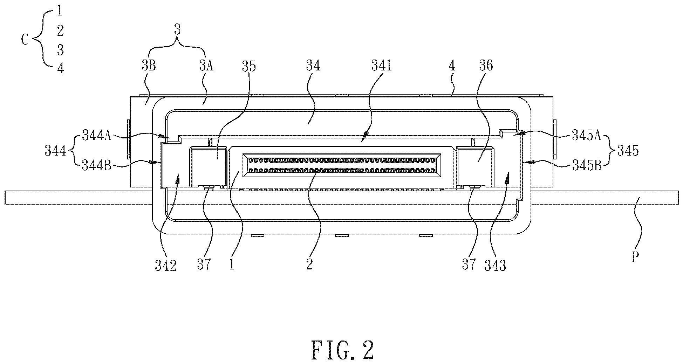

Referring to FIG. 2, FIG. 8, and FIG. 9, the front side of the metal housing 3 is formed with a front opening 31, and the rear side of the metal housing 3 is formed with a rear opening 32. The front opening 31 and the rear opening 32 are in communication with each other so that the insulating body 1 can be inserted into the metal housing 3 along a rear-to-front direction and be mounted in the metal housing 3, with the front opening 31 in communication with the mating groove 10 of the insulating body 1 to allow the tongue plate of the mating connector to be inserted into the mating groove 10 through the front opening 31. In addition, the bottom side of the metal housing 3 is formed with a lower opening 33 through which the rear sections of the metal terminals 2 can be exposed and be fixed on the circuit board P. The cover 4 is configured to be mounted on the rear side of the metal housing 3 to cover the rear opening 32 completely or partially, thereby providing proper protection to the insulating body 1 and metal terminals 2 and blocking foreign matter from the outside. However, in certain embodiments, based on product needs, the connector C can be dispensed with the cover 4. In certain embodiments, the metal housing 3 can have no rear opening 32. In certain embodiments, the metal housing 3 can have no lower opening 33 and the rear sections of the metal terminals 2 are exposed from the rear opening 32.

Referring to FIG. 2 and FIG. 6 to FIG. 9, the metal housing 3 has a first inner wall (e.g., the top inner wall or the bottom inner wall) provided with a blocking portion 34. The side of the blocking portion 34 that faces the insulating body 1 is spaced apart from the insulating body 1 by a first groove 341. The left inner wall and the right inner wall of the metal housing 3 face each other and are both adjacent to the first inner wall. The left inner wall is spaced apart from the left side of the insulating body 1 by a left groove 342, and the right inner wall is spaced apart from the right side of the insulating body 1 by a right groove 343. In certain embodiments, the left end of the first groove 341 is in communication with the left groove 342, and the right end of the first groove 341 is in communication with the right groove 343. However, the present disclosure is note limited thereto. In certain embodiments, only one of the left groove 342 and right groove 343 is in communication with the first groove 341. In certain embodiments, the first groove 341 is in communication neither with the left groove 342 nor with the right groove 343.

With continued reference to FIG. 2 and FIG. 6 to FIG. 9, the metal housing 3 is provided with a left guiding structure 344 and a right guiding structure 345. The left guiding structure 344 corresponds to the left groove 342, and the right guiding structure 345 corresponds to the right groove 343. In certain embodiments, the left guiding structure 344 and the right guiding structure 345 are formed by changing the inner-wall configuration of the blocking portion 34 (e.g., into a recessed or protruding configuration). The blocking portion 34 can be provided with a left guiding structure 344A at a position of the blocking portion 34 that corresponds to the left groove 342, and a right guiding structure 345A at a position of the blocking portion 34 that corresponds to the right groove 343. In certain embodiments, the left guiding structure 344A protrudes downward (i.e., has a protruding configuration), and the right guiding structure 345A is an upward recess (i.e., has a recessed configuration). Therefore, given the same horizontal reference plane (e.g., the top side of the circuit board P), the vertical height of the left groove 342 (i.e., the distance from the bottom side of the left guiding structure 344A to the horizontal reference plane) is different from the vertical height of the right groove 343 (i.e., the distance from the bottom side of the right guiding structure 345A to the horizontal reference plane). However, in certain embodiments, the configurations of the left guiding structure 344A and the right guiding structure 345A can be exchanged. In certain embodiments, the configurations of the left guiding structure 344A and the right guiding structure 345A can be the same. In certain embodiments, the metal housing 3 can have neither the left guiding structure 344A nor the right guiding structure 345A, and the vertical height of the left groove 342 is the same as the vertical height of the right groove 343.

With continued reference to FIG. 2 and FIG. 6 to FIG. 9, in certain embodiments, the left guiding structure 344 and the right guiding structure 345 are formed by changing the inner-wall configuration of the metal housing 3 (e.g., into a recessed or protruding configuration). The left inner wall of the metal housing 3 can be recessed to form a left guiding structure 344B, and the right inner wall of the metal housing 3 can be recessed to form a right guiding structure 345B. The vertical height of the left guiding structure 344B is different from the vertical height of the right guiding structure 345B. However, the present disclosure is note limited thereto. In certain embodiments, the configurations of the left guiding structure 344B and the right guiding structure 345B can be changed to protruding configurations. In certain embodiments, the configurations of the left guiding structure 344B and the right guiding structure 345B can be different from each other. In certain embodiments, the metal housing 3 can have neither the left guiding structure 344B nor the right guiding structure 345B. Based on the actual needs, the left guiding structure 344 of the metal housing 3 can be the left guiding structure 344A and/or the left guiding structure 344B, and the right guiding structure 345 of the metal housing 3 can be the right guiding structure 345A and/or the right guiding structure 345B.

When the connector C is connected with a mating connector, with continued reference to FIG. 2 and FIG. 6 to FIG. 9, the at least one structure of the mating connector that corresponds to at least one of the first groove 341, the left groove 342, and the right groove 343 is inserted into the at least one of the first groove 341, the left groove 342, and the right groove 343 such that the connector C and the mating connector are both limited in position in three directions (e.g., in the directions of their respective top sides, left sides, and right sides) and are thus securely joined together. In addition, the designs of the left guiding structure 344 and of the right guiding structure 345 help guide the at least one corresponding structure of the mating connector precisely into the at least one of the first groove 341, the left groove 342, and the right groove 343. Different configurations of the left and right guiding structures 344 and 345 have a foolproof effect. To make it easier for the at least one corresponding structure of the mating connector to slide into the at least one of the first groove 341, the left groove 342, and the right groove 343, the edge(s) of the blocking portion 34 that corresponds/correspond to the at least one of the first groove 341, the left groove 342, and the right groove 343 has/have an inclined surface that extends rearward.

Referring to FIG. 1 to FIG. 3, the metal housing 3 is divided into a front section 3A and a rear section 3B, and the front side of the blocking portion 34 can be located in the area of the vertical projection of the front section 3A, the area of the vertical projection of the rear section 3B, or the area of the vertical projection of the transition portion between the front section 3A and the rear section 3B. The front section 3A is in the form of a frame and has a vertical height greater than the vertical height of the rear section 3B. The horizontal length of the front section 3A can be less than the horizontal length of the rear section 3B. However, in certain embodiments, the horizontal length of the front section 3A is the same as or greater than the horizontal length of the rear section 3B. In certain embodiments, the metal housing 3 is made of cast iron. Of the four peripheral walls (e.g., the top wall, the left wall, the right wall, and the bottom wall) of the front section 3A, the thickest portion can have a thickness of 1.73 mm, and the thinnest portion can have a thickness of 1.23 mm. As cast iron has relatively high compressive strength and wear resistance, the metal housing 3 can resist external impact and wear effectively. The desirable thermal dissipation property of cast iron also helps reduce the accumulation of heat in the connector C after long-term use, thereby maintaining the working stability of the connector C.

Once the connector C is mounted on the circuit board P, with continued reference to FIG. 1 to FIG. 3, the front section 3A is located on the outer side of the front edge of the circuit board P and is spaced apart from the front edge of the circuit board P by a gap G (*see* FIG. 3). However, the present disclosure is not limited thereto, and in certain embodiments, the front section 3A can be flush with an edge of the circuit board P. As a portion of the metal housing 3 stays outside the circuit board P, more space on the circuit board P can be released to allow other electronic elements to be mounted on the circuit board P, and when the mating connector is inserted into the connector C, the front section 3A can withstand a greater force and thereby reduce the stress applied directly to the solder joints between the metal terminals 2 and the circuit board P. The front section 3A also provides adequate protection for the mating connector such that the connection stability and service lives of the connector C and the mating connector are effectively increased.

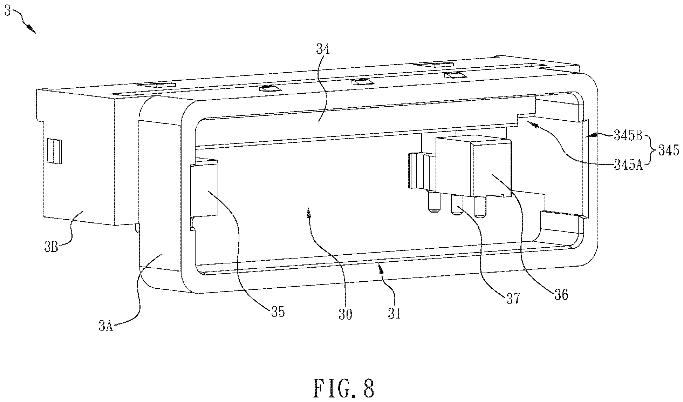

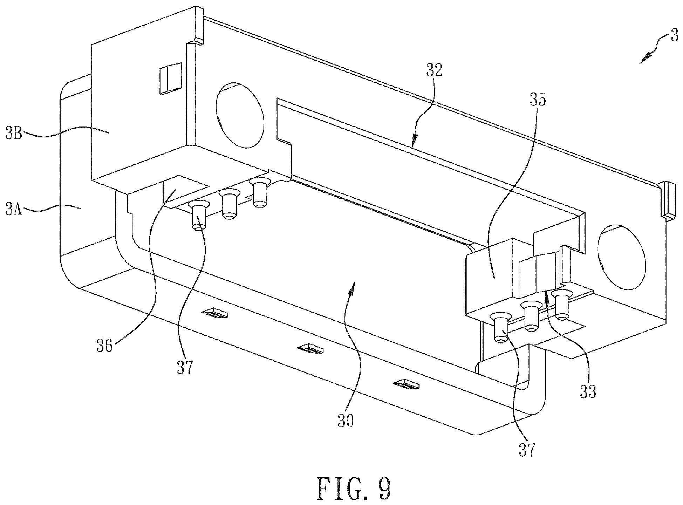

In certain embodiments, referring to FIG. 8 and FIG. 9, the metal housing 3 is provided therein with a left protecting post 35 and a right protecting post 36, both protruding forward, so as to provide the insulating body 1 with better protection. The left protecting post 35 is located in the left groove 342 while the right protecting post 36 is located in the right groove 343. In certain embodiments, the left protecting post 35 and the right protecting post 36 can have three-dimensional configurations such as rectangular columns. However, the present disclosure is not limited thereto. In certain embodiments, the left protecting post 35 and the right protecting post 36 can have such three-dimensional configurations as round columns or other non-rectangular columns. In certain embodiments, the metal housing 3 is provided therein with only one protecting post, for example, one of the left protecting post 35 and the right protecting post 36, and based on the position of the protecting post, it can have the structural features matching that of the left protecting post 35 or the right protecting post 36.

Referring to FIG. 2 and FIG. 6 to FIG. 9, the left protecting post 35 is spaced apart from the left inner wall of the metal housing 3 and does not occupy the entire left groove 342. The right protecting post 36 is spaced apart from the right inner wall of the metal housing 3 and does not occupy the entire right groove 343. However, the present disclosure is not limited thereto. A receiving space 30 is provided between the left protecting post 35 and the right protecting post 36. The receiving space 30 is for receiving the insulating body 1, and the horizontal width of the receiving space 30 can be greater than or equal to the horizontal width of the insulating body 1. Thus, the left protecting post 35 is located between the left inner wall of the metal housing 3 and the left side of the insulating body 1, and the right protecting post 36 is located between the right inner wall of the metal housing 3 and the right side of the insulating body 1. However, in certain embodiments, if only one protecting post is provided, the receiving space 30 will be formed between the protecting post and the farther one of the left and right inner walls of the metal housing 3 from the protecting post, and be in communication with the left groove 342 or the right groove 343. The left protecting post 35 and/or the right protecting post 36 is designed to produce the following effects:
(1) As the left and right sides of the insulating body 1 correspond to and are next to the left protecting post 35 and the right protecting post 36, respectively (or one of the left and right sides of the insulating body 1 corresponds to and is next to the single protecting post), the insulating body 1 is effectively prevented from being moved or deformed in the metal housing 3 by a lateral force or a squeezing/compressing action, which helps maintain the structural stability of the connector C. The lateral force or squeezing/compressing action may be attributable to a lack of precision in force application when the mating connector is being inserted into or removed from the connector C, an error in the mounting direction of the insulating body 1, or factors such as vibrations, external impact, and temperature variations.
(2) When the insulating body 1 is impacted in the course in which the mating connector is inserted into or removed from the connector C, the left protecting post 35 and the right protecting post 36 can absorb, or distribute, some of the impact to reduce the negative effect the impact has on the insulating body 1 and the metal terminals 2, thereby extending the service life of the connector C.
(3) The left protecting post 35 and the right protecting post 36 help reduce electromagnetic interference, ensuring the stability of signal transmission through the metal terminals 2, which in turn contributes to an improvement in signal quality, especially where high-speed signals are used or in a sensitive electrical environment.

Referring to FIG. 2 and FIG. 9, the bottom side of each of the left protecting post 35 and the right protecting post 36 is provided with a plurality of positioning posts 37. The positioning posts 37 are configured to be fixed on the circuit board P so that the metal housing 3 is securely positioned on the circuit board P. In certain embodiments, the number of the positioning posts 37 at the left protecting post 35 can be the same as or different from that at the right protecting post 36. In certain embodiments, only the left protecting post 35 or the right protecting post 36 is provided with positioning posts 37. In certain embodiments, neither the left protecting post 35 nor the right protecting post 36 is provided with positioning posts 37, and the positioning posts 37 is provided at the bottom side of another portion of the metal housing 3.

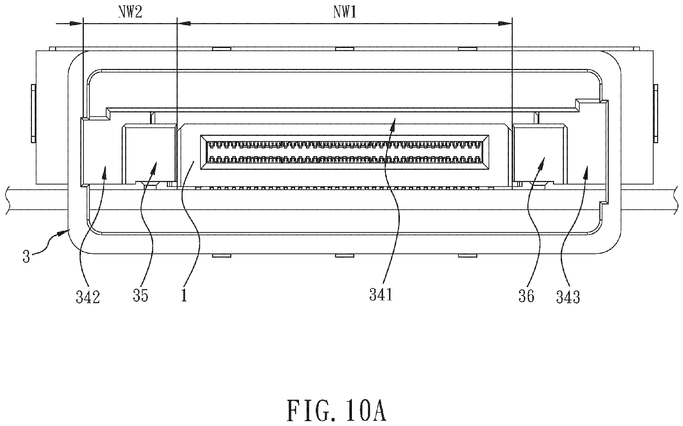

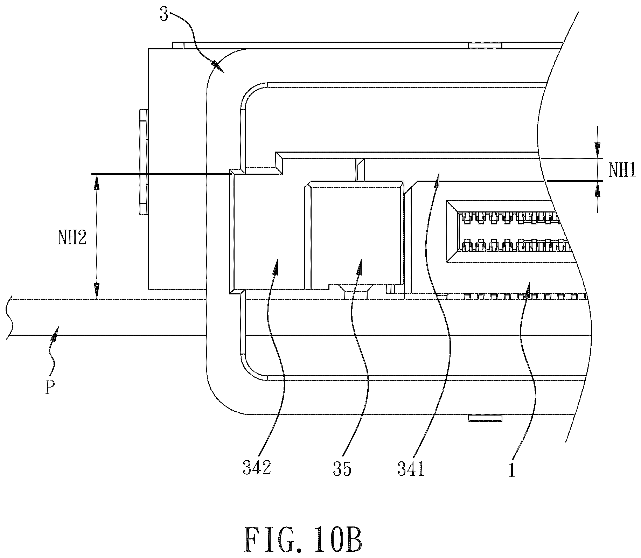

Referring to FIG. 2, FIG. 10A and FIG. 10B, according to the actual product needs, the first groove 341, the left groove 342 and/or the right groove 343 can have the following changes:
(1) As shown in FIG. 10A, the horizontal width NW1 of the first groove 341 is different from the horizontal width NW2 of the left groove 342; and the horizontal width NW1 of the first groove 341 can also be different from the horizontal width of the right groove 343.
(2) As shown in FIG. 10B, the height NH1 in the vertical direction of the first groove 341 is different from the height NH2 in the vertical direction of the left groove 342; and the height NH1 in the vertical direction of the first groove 341 can also be different from the height of the right groove 343 in the vertical direction;
(3) As shown in FIG. 2 and FIG. 10A to FIG. 10B, the height NH1 of the first groove 341 in the vertical direction is different from the horizontal width NW2 of the left groove 342; and the height NH1 in the vertical direction can also be different from the horizontal width of the right groove 343.

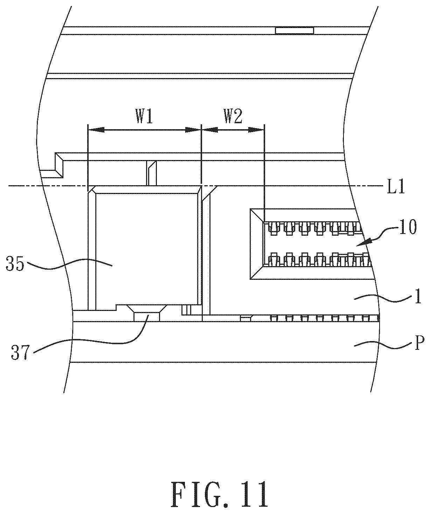

The left protecting post 35 and the right protecting post 36 can vary in design. To facilitate the presentation of different configurations of the protecting posts, the drawings referred to in this and the following paragraph(s) show only the left protecting post 35 by way of example; the right protecting post 36 can have the same features as the left protecting post 35. Referring to FIG. 11, which is a partial front view of the connector C, in conjunction with FIG. 2, the horizontal width W1 of the left protecting post 35 can be greater than the horizontal width W2 of the left wall of the insulating body 1. The phrase "the horizontal width W2 of the left wall of the insulating body 1" refers to the horizontal distance from the left side of the insulating body 1 to the mating groove 10. However, in certain embodiments, the horizontal width W1 of the left protecting post 35 can be the same as the horizontal width W2 of the left wall of the insulating body 1. That is, the horizontal width W1 of the left protecting post 35 is at least not smaller than the horizontal width W2 of the left wall of the insulating body 1. Similarly, the horizontal width of the right protecting post 36 can be at least not smaller than the horizontal width of the right wall of the insulating body 1. The phrase "the horizontal width of the right wall of the insulating body 1" refers to the horizontal distance from the right side of the insulating body 1 to the mating groove 10.

With continued reference to FIG. 11 in conjunction with FIG. 2, in certain embodiments, the height of the top side of the left protecting post 35 can be the same as the height of the top side of the left wall of the insulating body 1 (both heights making reference to the imaginary line L1 in FIG. 11). It is worth mentioning that in an actual product, the front end of the left protecting post 35 may have a chamfer or fillet; therefore, "the height of the top side" refers to the height of only the flat part of the top side of the left protecting post 35, i.e., excluding the chamfered or filleted part and the region transitioning to the chamfered or filleted part. However, in certain embodiments, the height of the top side of the left protecting post 35 can exceed the height of the top side of the left wall of the insulating body 1. In other words, the height of the top side of the left protecting post 35 is at least not lower than the height of the top side of the left wall of the insulating body 1. Similarly, the height of the top side of the right protecting post 36 is at least not lower than the height of the top side of the right wall of the insulating body 1. In addition, in order for the left protecting post 35 and the right protecting post 36 to carry out their intended function, with continued reference to the front view in FIG. 11, the vertical height of the left protecting post 35 is at least not less than two thirds of the vertical height of the left wall of the insulating body 1, wherein "the vertical height of the left protecting post 35" excludes the height of the positioning posts 37. Similarly, the vertical height of the right protecting post 36 is at least not smaller than two thirds of the vertical height of the right wall of the insulating body 1.

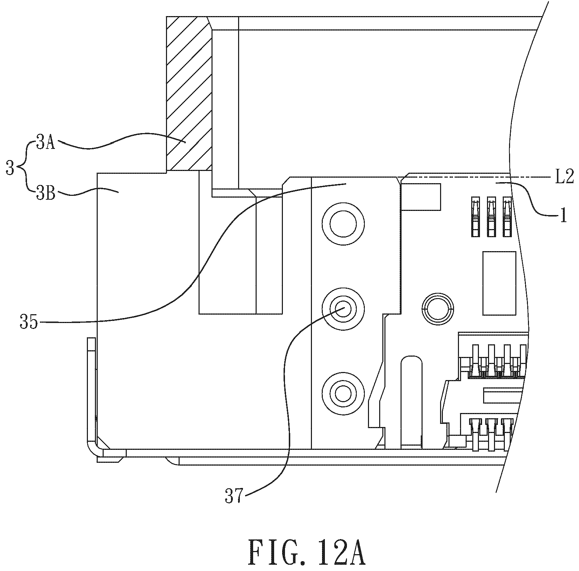

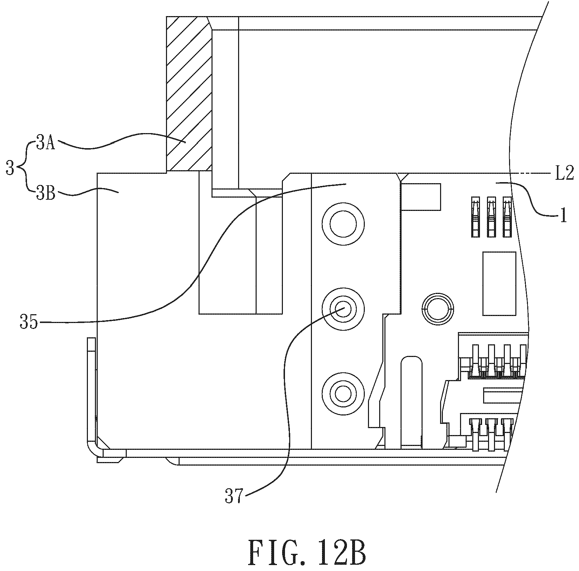

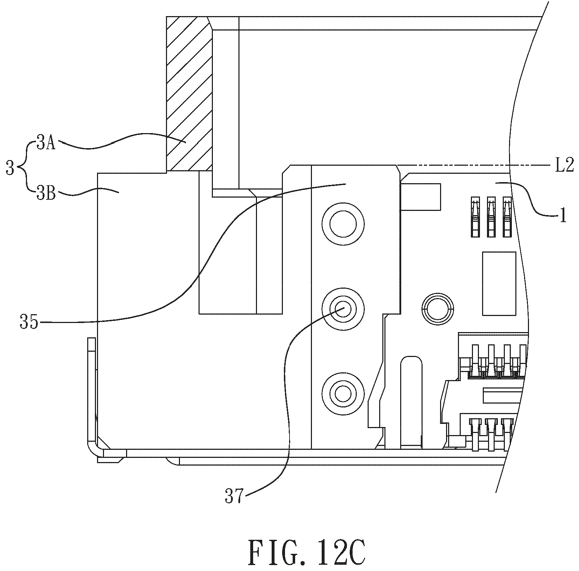

Moreover, based on actual product needs, with the front side of the left protecting post 35 serving as a reference (as indicated by the imaginary line L2 in FIG. 12A to FIG. 12C), it is feasible for the front side of the left protecting post 35 to not extend beyond the front side of the insulating body 1 (*see* FIG. 12A), to be flush with the front side of the insulating body 1 (*see* FIG. 12B), or to extend beyond the front side of the insulating body 1 (*see* FIG. 12C). It is worth mentioning that the foregoing "front side" excludes any chamfered or filleted part and the region transitioning thereto. Similarly, the front side of the right protecting post 36 can extend beyond or not beyond (including being flush with) the front side of the insulating body 1.

The foregoing description of the exemplary embodiments of the disclosure has been presented only for the purposes of illustration and description and is not intended to be exhaustive or to limit the disclosure to the precise forms disclosed. Many modifications and variations are possible in light of the above teaching.

The embodiments were chosen and described in order to explain the principles of the disclosure and their practical application so as to enable others skilled in the art to utilize the disclosure and various embodiments and with various modifications as are suited to the particular use contemplated. Alternative embodiments will become apparent to those skilled in the art to which the present disclosure pertains without departing from its scope.

## Claims

1. A connector, comprising:
an insulating body (1) formed with at least one mating groove (10) at a front side thereof;
a plurality of metal terminals (2) configured to be disposed in the insulating body (1), each having a front section configured to be exposed from the mating groove (10) and a rear section configured to extend out of the insulating body (1) and be fixed to a connection medium; and
a metal housing (3) formed with a front opening (31) at a front side thereof and configured to be mounted with the insulating body (1) therein,
wherein the front opening (31) is in communication with the mating groove (10); a first inner wall of the metal housing (3) is provided with a blocking portion (34), and a side of the blocking portion (34) that faces the insulating body (1) is spaced apart from the insulating body (1) by a first groove (341); and a left inner wall and a right inner wall of the metal housing (3) face each other and are both adjacent to the first inner wall, the left inner wall is spaced apart from the insulating body (1) by a left groove (342), and the right inner wall is spaced apart from the insulating body (1) by a right groove (343).

2. The connector according to claim 1, wherein a left end of the first groove (341) is in communication with the left groove (342), and a right end of the first groove (341) is in communication with the right groove (343).

3. The connector according to claim 1, wherein the metal housing (3) is divided into a front section (3A) and a rear section (3B), and the front section (3A) is in a form of a frame and has a vertical height greater than a vertical height of the rear section (3B).

4. The connector according to claim 1, wherein the metal housing (3) is provided with a left guiding structure (344) and a right guiding structure (345), the left guiding structure (344) corresponds to the left groove (342), and the right guiding structure (345) corresponds to the right groove (343).

5. The connector according to claim 4, wherein the left inner wall of the metal housing (3) is recessed to form the left guiding structure (344), and the right inner wall of the metal housing (3) is recessed to form the right guiding structure (345).

6. The connector according to claim 4, wherein a position of the blocking portion (34) that corresponds to the left groove (342) is provided with the left guiding structure (344), and a position of the blocking portion (34) that corresponds to the right groove (343) is provided with the right guiding structure (345).

7. The connector according to claim 6, wherein the left guiding structure (344) is of a recessed configuration and the right guiding structure (345) is of a protruding configuration, or the left guiding structure (344) is of a protruding configuration and the right guiding structure (345) is of a recessed configuration.

8. The connector according to claim 4, wherein a vertical height of the left guiding structure (344) is different from a vertical height of the right guiding structure (345).

9. The connector according to claim 1, wherein the metal housing (3) is provided therein with at least one protecting post that protrudes forward, and each of the at least one protecting post is located in the left groove (342) or the right groove (343) and corresponds to an outer side of a side wall of the insulating body (1).

10. The connector according to claim 9, wherein a horizontal width of the protecting post is equal to or greater than a horizontal width of the corresponding side wall of the insulating body (1).

11. The connector according to claim 9, wherein a height of a top side of the protecting post is equal to or greater than a height of a top side of the corresponding side wall of the insulating body (1).

12. The connector according to claim 11, wherein a vertical height of the left protecting post is equal to or greater than two thirds of a vertical height of the corresponding side wall of the insulating body (1).

13. The connector according to claim 9, wherein a front side of the protecting post does not extend beyond a front side of the insulating body (1).

14. The connector according to claim 9, wherein a front side of the protecting post extends beyond a front side of the insulating body (1).

15. The connector according to claim 9, wherein a bottom side of at least one of the protecting post and the metal housing (3) is provided with at least one positioning post.

16. A connector system, comprising:
a circuit board (P); and
a connector fixable to the circuit board (P), extending across or adjacent to an edge of the circuit board (P), and comprising:
an insulating body formed with at least one mating groove (10) at a front side thereof;
a plurality of metal terminals (2) configured to be disposed in the insulating body, each having a front section configured to be exposed from the mating groove (10) and a rear section configured to extend out of the insulating body and be fixed to a connection medium; and
a metal housing (3) formed with a front opening (31) at a front side thereof and configured to be mounted with the insulating body therein,
wherein the front opening (31) is in communication with the mating groove (10); a first inner wall of the metal housing (3) is provided with a blocking portion (34), and a side of the blocking portion (34) that faces the insulating body is spaced apart from the insulating body by a first groove (341); and a left inner wall and a right inner wall of the metal housing (3) face each other and are both adjacent to the first inner wall, the left inner wall is spaced apart from the insulating body by a left groove (342), and the right inner wall is spaced apart from the insulating body by a right groove (343); and
wherein the metal housing (3) is divided into a front section (3A) and a rear section (3B), the front section (3A) is in a form of a frame and has a vertical height greater than a vertical height of the rear section (3B), and the front section (3A) is located outside an edge of the circuit board (P).

## Amended claims

### Amended claims in accordance with Rule 137(2) EPC.

1. A connector, comprising:
an insulating body (1) formed with at least one mating groove (10) at a front side thereof;
a plurality of metal terminals (2) configured to be disposed in the insulating body (1), each having a front section configured to be exposed from the mating groove (10) and a rear section configured to extend out of the insulating body (1) and be fixed to a connection medium; and
a metal housing (3) formed with a front opening (31) at a front side thereof and configured to be mounted with the insulating body (1) therein, the metal housing (3) having a front section (3A) and a rear section (3B),
wherein the front opening (31) is in communication with the mating groove (10); a first inner wall of the metal housing (3) is provided with a blocking portion (34), the blocking portion (34) having a front side located in the area of the vertical projection of the transition portion between the front section (3A) and the rear section (3B), and a side of the blocking portion (34) that faces the insulating body (1) is spaced apart from the insulating body (1) by a first groove (341); and a left inner wall and a right inner wall of the metal housing (3) face each other and are both adjacent to the first inner wall, the left inner wall is spaced apart from the insulating body (1) by a left groove (342), and the right inner wall is spaced apart from the insulating body (1) by a right groove (343).

2. The connector according to claim 1, wherein a left end of the first groove (341) is in communication with the left groove (342), and a right end of the first groove (341) is in communication with the right groove (343).

3. The connector according to claim 1, wherein the metal housing (3) is divided into the front section (3A) and the rear section (3B), and the front section (3A) is in a form of a frame and has a vertical height greater than a vertical height of the rear section (3B).

4. The connector according to claim 1, wherein the metal housing (3) is provided with a left guiding structure (344) and a right guiding structure (345), the left guiding structure (344) corresponds to the left groove (342), and the right guiding structure (345) corresponds to the right groove (343).

5. The connector according to claim 4, wherein the left inner wall of the metal housing (3) is recessed to form the left guiding structure (344), and the right inner wall of the metal housing (3) is recessed to form the right guiding structure (345).

6. The connector according to claim 4, wherein a position of the blocking portion (34) that corresponds to the left groove (342) is provided with the left guiding structure (344), and a position of the blocking portion (34) that corresponds to the right groove (343) is provided with the right guiding structure (345).

7. The connector according to claim 6, wherein the left guiding structure (344) is of a recessed configuration and the right guiding structure (345) is of a protruding configuration, or the left guiding structure (344) is of a protruding configuration and the right guiding structure (345) is of a recessed configuration.

8. The connector according to claim 4, wherein a vertical height of the left guiding structure (344) is different from a vertical height of the right guiding structure (345).

9. The connector according to claim 1, wherein the metal housing (3) is provided therein with at least one protecting post that protrudes forward, and each of the at least one protecting post is located in the left groove (342) or the right groove (343) and corresponds to an outer side of a side wall of the insulating body (1).

10. The connector according to claim 9, wherein a horizontal width of the protecting post is equal to or greater than a horizontal width of the corresponding side wall of the insulating body (1).

11. The connector according to claim 9, wherein a height of a top side of the protecting post is equal to or greater than a height of a top side of the corresponding side wall of the insulating body (1).

12. The connector according to claim 11, wherein a vertical height of the left protecting post is equal to or greater than two thirds of a vertical height of the corresponding side wall of the insulating body (1).

13. The connector according to claim 9, wherein a front side of the protecting post does not extend beyond a front side of the insulating body (1).

14. The connector according to claim 9, wherein a front side of the protecting post extends beyond a front side of the insulating body (1).

15. The connector according to claim 9, wherein a bottom side of at least one of the protecting post and the metal housing (3) is provided with at least one positioning post.

16. A connector system, comprising:
a circuit board (P); and
a connector fixable to the circuit board (P), extending across or adjacent to an edge of the circuit board (P), the connector being according to claims 1 to 15.
